# EUROPÄISCHE PATENTSCHRIFT

(11) **EP 0 766 305 B1**
(45) Veröffentlichungstag und Bekanntmachung des Hinweises auf die Patenterteilung: **16.03.2005**
(21) Anmeldenummer: 96114485.4
(22) Anmeldetag: 10.09.1996
(51) Int. Cl.: H01L 21/8248, H01L 21/84, H01L 27/12

(54) **Verfahren zur Herstellung von BiCMOS-Schaltungen auf SOI**
Method of producing BiCMOS circuits on SOI
Procédé de fabrication des circuits BiCMOS sur SOI

(30) Priorität: 28.09.1995 DE 19536249
(43) Veröffentlichungstag der Anmeldung: 02.04.1997
(73) Patentinhaber: Infineon Technologies AG, 81669 München (DE)
(72) Erfinder: Müller, Karlheinz, Ing., 84478 Waldkraiburg (DE)
(74) Vertreter: Zimmermann & Partner

(56) Entgegenhaltungen:
- EP-A- 0 276 692
- EP-A- 0 591 672
- EP-A- 0 632 490
- US-A- 4 677 735
- US-A- 5 262 344
- PARKE S ET AL: "A VERSATILE, SOI BICMOS TECHNOLOGY WITH COMPLEMENTARY LATERAL BJT'S" INTERNATIONAL ELECTRON DEVICES MEETING 1992, SAN FRANCISCO, DEC. 13 - 16, 1992, 13. Dezember 1992 (1992-12-13), Seiten 453-456, XP000687468 INSTITUTE OF ELECTRICAL AND ELECTRONICS ENGINEERS ISBN: 0-7803-0818-2
- PATENT ABSTRACTS OF JAPAN vol. 018, no. 105 (E-1512), 21. Februar 1994 (1994-02-21) & JP 05 304164 A (TOSHIBA CORP), 16. November 1993 (1993-11-16)

## Beschreibung

Die Erfindung betrifft ein Verfahren zur Herstellung einer Vielzahl von mikroelektronischen Schaltungen auf SOI. Dabei werden insbesondere CMOS-Transistoren und/oder bipolare Transistoren hergestellt.

Bekannt sind eine Reihe verschiedener Verfahren, mit denen mikroelektronische Schaltungen und auch CMOS-Schaltungen oder bipolare Transistoren hergestellt werden können. Die Verfahren unterscheiden sich jedoch beträchtlich voneinander und lassen sich nicht oder nur mit großem Aufwand miteinander kombinieren.

So beschreibt beispielsweise die EP-A-0 591 672 ein Verfahren, bei dem ein SOI-Wafer in einen Bipolartransistorbereich und einen MOS-Transistorbereich unterteilt wird. Dabei wird ein Bipolartransitor im Bipolartransitorbereich ausgebildet, der sowohl einen aktiven wie auch einen inaktiven Basisbereich aufweist, die miteinander verbunden sind. Gleichzeitig wird ein MOS-Transistor im MOS-Transistorbereich ausgebildet. Zur elektrischen Kontaktierung werden in beiden Transistorbereichen Silizidschichten gebildet.

Die US-A-4 677 735 beschreibt ein Verfahren, bei dem nur eine einzige Schicht eines Silizids als Kontakt über einer als Gate dienenden n⁺-dotierten Polysiliziumschicht angeordnet ist. Auch dieses Verfahren beruht auf einem SOI-Prozeß.

Der Erfindung liegt die Aufgabe zugrunde, ein Verfahren zu schaffen, welches sich zur Herstellung einer Vielzahl von verschiedenen mikroelektronischen Strukturen auf SOI und insbesondere von CMOS-Strukturen und bipolaren Transistoren eignet.

Die Lösung dieser Aufgabe erfolgt mit den Merkmalen des Anspruchs 1. Vorteilhafte Weiterbildungen sind in den Unteransprüchen beschrieben.

Nach dem Grundgedanken der Erfindung wird in dem Isolatormaterial eine Vielzahl von aktiven Bereichen definiert, in den aktiven Bereichen jeweils in Abhängigkeit von der zu erzeugenden Struktur eine n-Wanne oder eine p-Wanne implantiert, Gateoxid erzeugt und in Teilbereichen der aktiven Bereiche definiert, eine erste Polysiliziumschicht aufgebracht, in Abhängigkeit von der zu erzeugenden Struktur eine n⁺ oder p⁺ Implantation durchgeführt und mit einer späteren Temperaturbehandlung zwei äußere, darunterliegende Bereiche der Wanne dotiert, eine Oxidschicht aufgebracht, die Oxidschicht und die darüber liegenden Bereiche zur Definition der aktiven Gebiete geätzt, eine Oxidschicht aufgebracht und aus dieser an den geätzten Polysiliziumstrukturen der aktiven Gebiete Spacer geätzt, eine zweite Polysiliziumschicht aufgebracht, in Abhängigkeit von der zu erzeugenden Struktur eine p- oder n- Implantation durchgeführt, die zweite Polysiliziumschicht strukturiert und mit einer Oxidbeschichtung versehen, an den erzeugten Flanken Spacer geätzt, mit einer Temperaturbehandlung die implantierten Dotierstoffe aus der ersten und der zweiten Polysiliziumschicht in die darunterliegenden Wannenbereiche diffundiert, die freiliegenden Polysiliziumschichten durch Einbringung eines geeigneten Metalls siliziert und metallische Kontakte erzeugt.

Durch das erfindungsgemäße Verfahren besteht die Möglichkeit, auf einem Wafer eine Vielzahl von aktiven Bereichen zu definieren und unter Verwendung des gleichen Prozeßblocks eine Vielzahl von verschiedenen Strukturen herstellen zu können, wobei lediglich die Dotierungen angepaßt werden müssen.

Zur Herstellung einer n-CMOS-Struktur wird zunächst eine p-Wanne implantiert, durch Implantation in der darüberliegenden Polysiliziumschicht und anschließendes Ausheilen eine n⁺ Source/Drain- und Gate-Implantation und im abschließenden Implantationsschritt eine beidseitige n- LDD-Implantation durchgeführt. Bei der Herstellung einer p-CMOS-Struktur muß hingegen zunächst eine n-Wanne implantiert und anschließend durch Implantation in der ersten Polysiliziumschicht und Ausheilen eine p+ Source/Drain- und Gate-Implantation sowie abschließend eine beidseitige p- LDD-Implantation durchgeführt werden.

In einer anderen bevorzugten Ausführungsform wird bei der Herstellung eines NPN-Transistors zunächst eine n-Wanne implantiert und dann zur Herstellung der Emitter- und Kollektorbereiche eine n⁺ Implantation in der ersten Polysiliziumschicht in Verbindung mit einem Ausheilprozeß zur Diffusion der Dotieratome von der Polysiliziumschicht in die darunterliegenden Wannenbereiche und später eine einseitige p⁻ Implantation zur Erzeugung der Basis durchgeführt. Für die Herstellung eines PNP-Transistors wird zunächst eine p-Wanne erzeugt und mit der anschließenden p⁺ Dotierung Emitter- und Kollektorbereiche erzeugt und mit der späteren n⁻ Implantation die Basis hergestellt.

Besonders günstig ist es, auf einem Wafer eine Vielzahl von gleichen Strukturen zu erzeugen. Auf diese Weise kann in einer Prozeßfolge eine Vielzahl von elektronischen Bauelementen erzeugt werden. Ebenso gut sind natürlich auch auf einem Wafer verschiedene Strukturen herstellbar. Dazu müssen innerhalb des erfindungsgemäß standardisierten Prozesses verschiedene Implantationen durchgeführt werden.

Bei der Transistorherstellung ist eine besonders günstige Ausführungsform die zweiseitige Spacerbildung, durch die die Basisweiten der Transistoren besonders gering eingestellt werden können.

Durch das erfindungsgemäße Verfahren wird ein High-Performance-BiCMOS-Prozeß auf SOI realisiert, in dem zwei Polysiliziumschichten für die CMOS-Strukturen und laterale bipolare Transistoren verwendet werden. Durch die Diffusion des Dotierstoffes von Polysilizium in Monosilizium erhält man außerdem lateral steile Dotierstoffprofile. Der erfindungsgemäße Prozeß ist mit und ohne Kontaktloch möglich. Bei Ausbildung eines Kontaktloches werden die Kontakte auf das Polysilizium geführt, während sie in Standardprozessen auf das Monosilizium geführt werden. Dabei hat man jedoch das Problem, daß Anätzungen im Bereich des Monosiliziums stattfinden. Wegen der in SOI-Prozessen verwendeten dünnen Siliziumschichten kann eine solche Anätzung kritisch sein. Vorteilhaft ist also die bei diesem Verfahren mögliche Kontaktierung durch Kontaktlöcher, wobei die Kontakte auf das Polysilizium geführt werden.

Zur Dotierung der einzelnen Wannenbereiche werden in den darüberliegenden Polysiliziumschichten Dotierstoffe implantiert und in einem anschließenden Ausheilprozeß diese Dotierstoffe aus dem Polysilizium in die darunterliegenden Bereiche der Wanne diffundiert. Ein solcher Ausheilschritt kann nach jeder einzelnen Implantation durchgeführt werden. Bevorzugt wird jedoch nur ein gemeinsamer Ausheilprozeß nach der letzten Implantation durchgeführt.

Nachfolgend wird die Erfindung anhand eines in der Zeichnung dargestellten Ausführungsbeispiels näher erläutert. Im einzelnen zeigen die schematischen Darstellungen in:
- Figuren 1 bis 6: verschiedene Verfahrensstände während des Prozeßablaufs;
- Figur 7: einen mit dem erfindungsgemäßen Verfahren erzeugten n-CMOS-Transistor;
- Figur 8: einen mit dem erfindungsgemäßen Verfahren erzeugten p-CMOS-Transistor;
- Figur 9: einen mit dem erfindungsgemäßen Verfahren hergestellten NPN-Transistor; und
- Figur 10: einen mit dem erfindungsgemäßen Verfahren hergestellten PNP-Transistor.

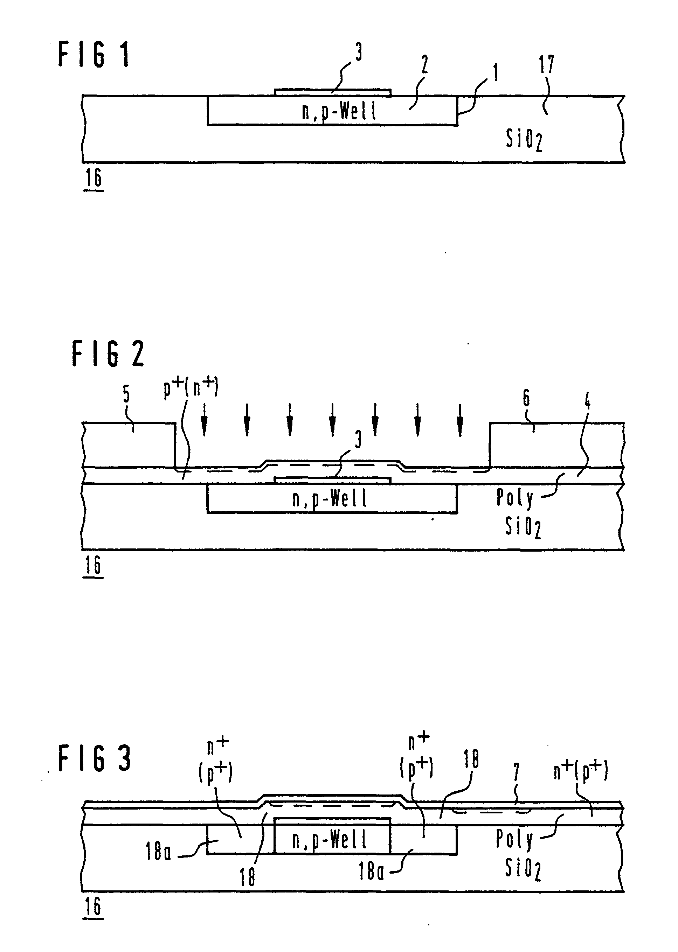

Zu Beginn des Verfahrens wird auf ein Substrat 16 eine Siliziumdioxidschicht 17 und eine darüberliegende Siliziumschicht aufgebracht. Die aktiven Bereiche 1 werden durch MESA-Ätzung oder Oxidation in der Siliziumschicht definiert. Ein so erzeugter aktiver Bereich 1 ist in Figur 1 dargestellt. Auf dem verwendeten Wafer werden eine Vielzahl von aktiven Bereichen 1 definiert, in denen jeweils eine Struktur erzeugt wird. Zur einfacheren Darstellung ist in den Figuren immer nur ein aktiver Bereich 1 dargestellt. Mit einer Maskentechnik werden die Gebiete außerhalb der aktiven Bereiche abgedeckt und in den aktiven Bereichen 1 durch eine I²-Implantation eine n-Wanne 2 oder eine p-Wanne 2 erzeugt. Diese werden auch als Well bezeichnet und bestehen aus Monosilizium. Die Auswahl der Dotieratome hängt von der zu erzeugenden Struktur ab. So wird für einen n-CMOS oder einen PNP-Transistor eine p-Wanne und für einen p-CMOS oder einen NPN-Transistor eine n-Wanne erzeugt. Die so implantierte Wanne wird durch Temperaturbehandlung ausgeheilt. Anschließend wird ein Gateoxid 3 aufgebracht, mit einer weiteren Maskentechnik strukturiert und SiO₂ geätzt, so daß das Gateoxid 3 nur einen Teilbereich der aktiven Bereiche 1 abdeckt.

In den nächsten, in Figur 2 dargestellten Schritten wird eine erste Polysiliziumschicht 4 ganzflächig aufgebracht. In dieser Polysiliziumschicht 4 können durch n⁻ oder p⁻ Implantationen Hochohm-Widerstände erzeugt werden, die zur Verbindung und zum weiteren Anschluß der erzeugten Strukturen dienen. Weiterhin wird eine Lackmaske mit Bereichen 5 und 6 aufgebracht, mit der eine n⁺ oder eine p⁺ Implantation durchgeführt wird. Bei der Herstellung der CMOS-Strukturen dienen diese Implantationen zur Source/Drain-Implantation und zur Gatedotierung und bei der Herstellung von Transistoren zur Emitter- und Kollektorherstellung. Außerdem kann beispielsweise mit der n⁺ Implantation ein Basisanschluß für den PNP-Transistor oder können Kapazitäten und Widerstände erzeugt werden. Umgekehrt kann mit der n⁻ Implantation ein Basisanschluß für den NPN-Transistor oder können Kapazitäten und Widerstände erzeugt werden.

Auf diese Weise entstehen n⁺ oder p⁺ dotierte Bereiche 18 in der Polysiliziumschicht 4. Jetzt könnte ein erster Ausheilschritt erfolgen, bei dem die Dotieratome auch in die darunterliegenden Bereiche 18a der Wanne 2 diffundieren. Das Gateoxid 3 stellt eine Diffusionsbremse.dar, so daß in diesem mittleren Bereich keine weitere Dotierung der Wanne 2 stattfindet. Weiterhin wird auf die erste Polysiliziumschicht 4 eine Oxidschicht 7 aufgebracht, die sich genau wie die darunter liegende erste Polysiliziumschicht über den gesamten Wafer erstreckt. Erst in den folgenden Schritten werden die zunächst ganzflächig aufgebrachten Schichten für die Verwendung innerhalb der jeweiligen aktiven Bereiche 1 strukturiert. Dieser Verfahrensstand ist in Figur 3 dargestellt.

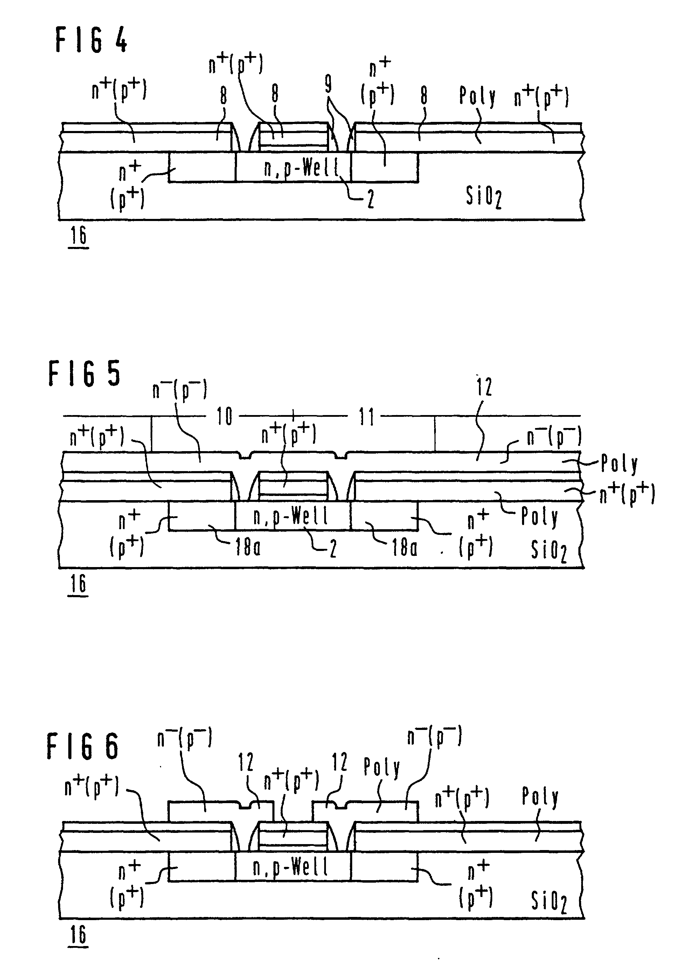

So ist in Figur 4 dargestellt, wie mit einer weiteren Maskentechnik die aktiven Bereiche 8 erzeugt werden, wobei die Oxidschicht 7, die erste Polysiliziumschicht 4 und das darunter liegende Gateoxid 3 bis zur darunter liegenden Wanne 2 geätzt werden. Auf die so erzeugte Struktur wird eine Oxidschicht aufgebracht und mit einer Spacertechnik werden Spacer 9 an den Flanken dieser Struktur geätzt.

Eine zweite Polysiliziumschicht 12 wird aufgebracht, die auch die vorher erzeugten Zwischenräume füllt, sich an die Spacer 9 anlegt und bis zur Wanne 2 herunterreicht. Auf diese zweite Polysiliziumschicht 12 wird, wie in Figur 5 dargestellt, eine Lackmaske 10, 11 aufgebracht, mit deren Hilfe eine p- oder n- I²-Implantation durchgeführt wird. Mit der p- I²-Implantation läßt sich im NPN-Transistor die Basis erzeugen oder im p-CMOS eine LDD-Implantation durchführen. Analog würde mit der n⁻ I²-Implantation die Basis des PNP-Transistors erzeugt oder im n-CMOS eine LDD-Implantation durchgeführt.

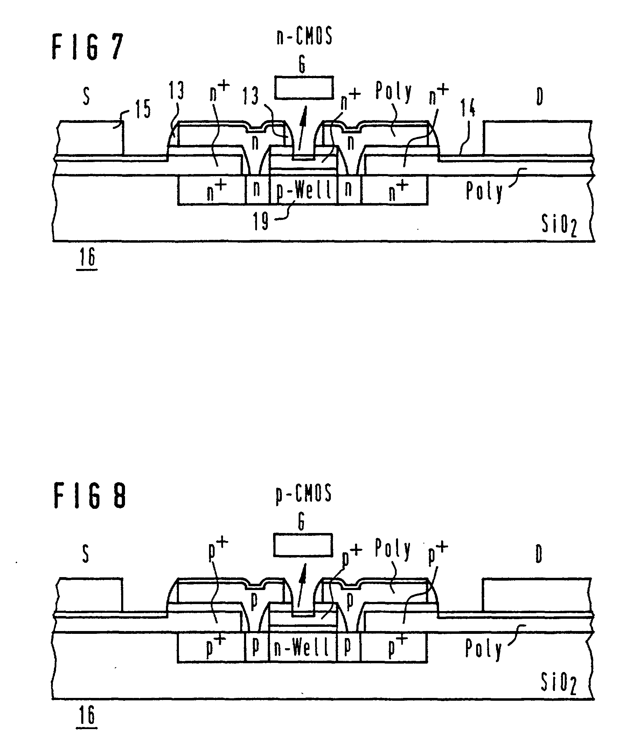

Mit einer weiteren Maskentechnik wird die zweite Polysiliziumschicht 12 geätzt und dadurch strukturiert. Die so erzeugten Strukturen sind in Figur 6 dargestellt. Mit einer weiteren Temperaturbehandlung werden die Dotierstoffe aus der Polysiliziumschicht 12 in die darunterliegenden Monosiliziumbereiche der Wanne 2 diffundiert. Diese Bereiche liegen zwischen den vorher erzeugten äußeren n⁺ bzw. p⁺ dotierten Bereichen 18a und dem zentralen Bereich 19 der Wanne. Dieser Ausheilprozeß kann auch unter Auslassung der vorhergehenden Ausheilprozesse als einziger durchgeführt werden. Dabei würden dann gleichzeitig die Dotierstoffe aus den Bereichen 18 der ersten Polysiliziumschicht 4 in die darunterliegenden äußeren Bereiche 18a der Wanne 2 und die Dotierstoffe aus der zweiten Polysiliziumschicht 12 in die eben beschriebenen 5 Bereiche der Wanne 2 diffundiert. Weiterhin wird eine Oxidbeschichtung vorgenommen, und wie beispielsweise in Figur 7 zu sehen ist, werden an den Kanten der in der zweiten Polysiliziumschicht 12 erzeugten Strukturen Spacer geätzt. In den freiliegenden Bereichen der Polysiliziumschicht 4 und der vorher mit Oxid beschichteten zweiten Siliziumschicht 12 wird ein geeignetes Metall aufgebracht und so ein Silizid 14 erzeugt. Der hier verwendete Prozeß ist ein Salizidprozeß. Weiterhin werden zur Kontaktierung metallische Kontakte 15 aufgebracht.

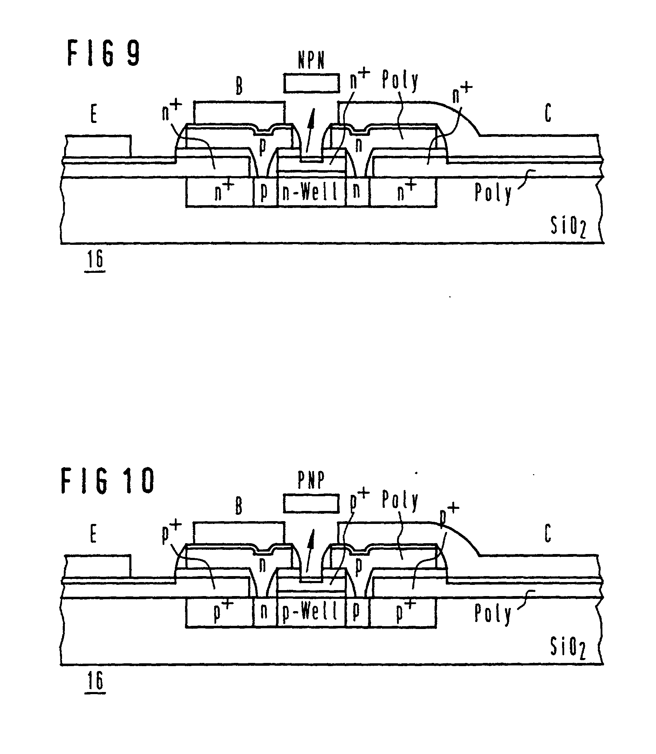

Mit diesem Verfahren herstellbare Strukturen sind in den Figuren 7 bis 10 dargestellt. Dabei ist in Figur 7 ein n-CMOS-Transistor, in Figur 8 ein p-CMOS-Transistor, in Figur 9 ein NPN-Transistor und in Figur 10 ein PNP-Transistor dargestellt. S steht für Source, D für Drain und G für Gate. Die Bezeichnungen E, B und C bei den Transistoren stehen für Emitter, Basis und Kollektor. Über dem zentralen Bereich der Wanne 19 ist über einen Pfeil angedeutet, daß dort ebenfalls ein metallischer Kontakt vorgesehen ist.

## Patentansprüche

1. Verfahren zur Herstellung einer Vielzahl von mikroelektronischen Schaltungen auf SOI, insbesondere von CMOS-Transistoren und/oder bipolaren Transistoren, mit den folgenden Schritten
(a) in einer über dem Isolatormaterial liegenden Siliziumschicht eine Vielzahl von aktiven Bereichen (1) definiert werden,
(b) in den aktiven Bereichen (1) jeweils in Abhängigkeit von der zu erzeugenden Struktur eine n-Wanne oder eine p-Wanne (2) implantiert wird,
(c) ein Gateoxid (3) erzeugt und auf den aktiven Bereichen (1) so strukturiert wird, daß es nur einen Teilbereich der aktiven Bereiche (1) abdeckt,
(d) eine erste Polysiliziumschicht (4) ganzflächig aufgebracht wird,
(e) in Abhängigkeit von der zu erzeugenden Struktur eine n⁺- oder p⁺-Implantation in dieser Polysiliziumschicht durchgeführt wird
(f) eine erste Oxidschicht (7) ganzflächig aufgebracht wird,
(g) die erste Oxidschicht (7), die darunterliegende erste Polysiliziumschicht (4) und das darunterliegende Gateoxid (3) bis zur darunterliegenden Wanne (2) zur Definition der aktiven Gebiete (8) geätzt werden,
(h) eine zweite Oxidschicht auf die so erzeugten Strukturen aufgebracht wird und aus dieser an den geätzten Polysiliziumstrukturen der aktiven Gebiete (8) Spacer (9) geätzt werden,
(i) eine zweite Polysiliziumschicht (12) aufgebracht wird,
(j) in Abhängigkeit von der zu erzeugenden Struktur eine p⁻- oder n⁻-Implantation durchgeführt wird,
(k) die zweite Polysiliziumschicht (12) strukturiert wird,
(l) eine Temperaturbehandlung durchgeführt wird, wobei die implantierten Dotierstoffe aus der ersten Polysiliziumschicht (4) in einen darunterliegenden äußeren Bereich (18a) der Wanne (2) diffundieren, und wobei die implantierten Dotierstoffe aus der zweiten Polysiliziumschicht (12) in einen zwischen dem äußeren Bereich (18a) und einem zentralen Bereich (19) der Wanne gelegenen Bereich diffundieren,
(m) eine dritte Oxidschicht aufgebracht wird,
(n) an den Kanten der in der zweiten Polysiliziumschicht erzeugten Strukturen Spacer (13) geätzt werden,
(o) die erste Oxidschicht (7) in ihren freiliegenden Bereichen entfernt wird,
(p) die erste und die zweite Polysiliziumschicht (4, 12) in ihren freiliegenden Bereichen durch Einbringung eines geeigneten Metalls siliziert werden, und
(q) metallische Kontakte (15) auf dem Silizid (14) erzeugt werden.

2. Verfahren nach Anspruch 1,
**dadurch gekennzeichnet, daß**
zwischen Schritt (e) und Schritt (f) eine weitere Temperaturbehandlung durchgeführt wird, so daß die implantierten Dotierstoffe aus der ersten Polysiliziumschicht (4) in einen darunterliegenden äußeren Bereich (18a) der Wanne (2) diffundieren.

3. Verfahren nach Anspruch 2,
**dadurch gekennzeichnet, daß**
Schritt (l) erst nach den Schritten (m) und (n) ausgeführt wird.

4. Verfahren nach einem der Ansprüche 1 bis 3,
**dadurch gekennzeichnet, daß**
zur Herstellung einer n-CMOS-Struktur zunächst in Schritt (b) eine p-Wanne (2) implantiert wird, in Schritt (e) die äußeren Bereiche (18a) der Wanne durch Dotieren der ersten Polysiliziumschicht (4) und Ausheilen n⁺ dotiert werden und anschließend in Schritt (j) in den Bereichen zwischen den äußeren Bereichen (18a) und dem zentralen Bereich (19) der Wanne eine beidseitige n⁻-Dotierung durchgeführt wird.

5. Verfahren nach einem der Ansprüche 1 bis 3,
**dadurch gekennzeichnet, daß**
zur Herstellung einer p-CMOS-Struktur zunächst in Schritt (b) eine n-Wanne (2) implantiert wird, in Schritt (e) die äußeren Bereiche (18a) der Wanne durch Dotierung der ersten Polysiliziumschicht (4) p⁺ dotiert werden und anschließend in Schritt (j) in den Bereichen zwischen den äußeren Bereichen (18a) und dem zentralen Bereich (19) eine beidseitige p⁻-Dotierung der zweiten Polysiliziumschicht (12) durchgeführt wird.

6. Verfahren nach einem der Ansprüche 1 bis 3,
**dadurch gekennzeichnet, daß**
zur Herstellung eines npn-Transistors zunächst in Schritt (b) eine n-Wanne (2) implantiert wird, in Schritt (e) die Bereiche (18) der ersten Polysiliziumschicht (4) n⁺ dotiert werden und anschließend in Schritt (j) in einem Bereich zwischen einem äußeren Bereich (18a) und dem zentralen Bereich (19) der Wanne zur Basiserzeugung eine einseitige p⁻-Dotierung durchgeführt wird.

7. Verfahren nach einem der Ansprüche 1 bis 3,
**dadurch gekennzeichnet, daß**
zur Herstellung eines pnp-Transistors zunächst in Schritt (b) eine p-Wanne (2) implantiert wird, in Schritt (e) die Bereiche (18) der ersten Polysiliziumschicht (4) p⁺ dotiert werden und anschließend in Schritt (j) in einem Bereich zwischen einem äußeren Bereich (18a) und dem zentralen Bereich (19) der Wanne eine einseitige n⁻-Dotierung zur Basiserzeugung durchgeführt wird.

8. Verfahren nach einem der vorhergehenden Ansprüche,
**dadurch gekennzeichnet, daß**
eine Vielzahl von gleichartigen Strukturen erzeugt wird.

9. Verfahren nach einem der Ansprüche 6 bis 8,
**dadurch gekennzeichnet, daß**
bei der Transistorherstellung die Basisweite durch zweiseitige Spacer (9) eingestellt wird.

10. Verfahren nach einem der vorhergehenden Ansprüche,
**dadurch gekennzeichnet, daß**
die Kontaktierung des Polysiliziums durch Kontaktlöcher erfolgt.

## Claims

1. Method for producing a multiplicity of microelectronic circuits on SOI, in particular CMOS transistors and/or bipolar transistors, having the following steps:
(a) a multiplicity of active regions (1) are defined in a silicon layer lying above the insulator material,
(b) an n-type well or a p-type well (2) is implanted in the active regions (1) in each case in a manner dependent on the structure to be produced,
(c) a gate oxide (3) is produced and patterned on the active regions (1) in such a way that it covers only a partial region of the active regions (1),
(d) a first polysilicon layer (4) is applied over the whole area,
(e) an n⁺-type or p⁺-type implantation is carried out in the said polysilicon layer in a manner dependent on the structure to be produced,
(f) a first oxide layer (7) is applied over the whole area,
(g) the first oxide layer (7), the underlying first polysilicon layer (4) and the underlying gate oxide (3) are etched as far as the underlying well (2) for definition of the active zones (8),
(h) a second oxide layer is applied to the structures thus produced and spacers (9) are etched from the said layer at the etched polysilicon structures of the active zones (8),
(i) a second polysilicon layer (12) is applied,
(j) a p⁻-type or n⁻-type implantation is carried out in a manner dependent on the structure to be produced,
(k) the second polysilicon layer (12) is patterned,
(l) a thermal treatment is carried out, the implanted dopants from the first polysilicon layer (4) diffusing into an underlying outer region (18a) of the well (2), and the implanted dopants from the second polysilicon layer (12) diffusing into a region located between the outer region (18a) and a central region (19) of the well,
(m) a third oxide layer is applied,
(n) spacers (13) are etched at the edges of the structures produced in the second polysilicon layer,
(o) the first oxide layer (7) is removed in its uncovered regions,
(p) the first and the second polysilicon layer (4, 12) are siliconized in their uncovered regions by introduction of a suitable metal, and
(q) metallic contacts (15) are produced on the silicide (14).

2. Method according to Claim 1,
**characterized in that**
a further thermal treatment is carried out between step (e) and step (f), so that the implanted dopants from the first polysilicon layer (4) diffuse into an underlying outer region (18a) of the well (2).

3. Method according to Claim 2,
**characterized in that**
step (l) is not performed until after steps (m) and (n) .

4. Method according to one of Claims 1 to 3,
**characterized in that**
in order to produce an n-CMOS structure, firstly in step (b) a p-type well (2) is implanted, in step (e) the outer regions (18a) of the well are n⁺-doped by doping of the first polysilicon layer (4) and annealing, and then in step (j) a two-sided n⁻-type doping is carried out in the regions between the outer regions (18a) and the central region (19) of the well.

5. Method according to one of Claims 1 to 3, **characterized in that**
in order to produce a p-CMOS structure, firstly in step (b) an n-type well (2) is implanted, in step (e) the outer regions (18a) of the well are p⁺-doped by doping of the first polysilicon layer (4), and then in step (j) a two-sided p⁻-type doping of the second polysilicon layer (12) is carried out in the regions between the outer regions (18a) and the central region (19).

6. Method according to one of Claims 1 to 3,
**characterized in that**
in order to produce an npn transistor, firstly in step (b) an n-type well (2) is implanted, in step (e) the regions (18) of the first polysilicon layer (4) are n⁺-doped, and then in step (j) a single-sided p⁻-type doping is carried out in a region between an outer region (18a) and the central region (19) of the well for the purpose of producing a base.

7. Method according to one of Claims 1 to 3,
**characterized in that**
in order to produce a pnp transistor, firstly in step (b) a p-type well (2) is implanted, in step (e) the regions (18) of the first polysilicon layer (4) are p⁺-doped, and then in step (j) a single-sided n⁻-type doping is carried out in a region between an outer region (18a) and the central region (19) of the well for the purpose of producing a base.

8. Method according to one of the preceding claims,
**characterized in that**
a multiplicity of structures of identical type are produced.

9. Method according to one of Claims 6 to 8,
**characterized in that**
in the course of transistor production, the base width is set by two-sided spacers (9).

10. Method according to one of the preceding claims,
**characterized in that**
the contact-connection of the polysilicon is effected through contact holes.

## Revendications

1. Procédé de production d'une pluralité de circuits microélectroniques sur SOI, notamment de transistors CMOS et/ou de transistors bipolaires comprenant les stades suivants :
(a) on définit une pluralité de zones (1) actives dans une couche de silicium se trouvant sur le matériau isolant,
(b) on implante dans les zones (1) actives une cuvette du type n ou une cuvette (2) du type p en fonction de la structure à produire,
(c) on produit un oxyde (3) de grille et on structure sur les zones (1) actives de façon à ce qu'il ne recouvre qu'une région partielle des zones (1) actives,
(d) on dépose sur toute la surface une première couche (4) de polysilicium,
(e) on effectue une implantation du type n⁺- ou une implantation du type p⁺- dans cette couche de polysilicium en fonction de la structure à produire,
(f) on dépose sur toute la surface une première couche (7) d'oxyde,
(g) on attaque la première couche (7) d'oxyde, la première couche (4) de polysilicium sous-jacente et l'oxyde (3) de grille sous-jacent jusqu'à la cuvette (2) sous-jacente pour la définition des domaines (8) actifs,
(h) on dépose une deuxième couche d'oxyde sur les structures ainsi produites et on ménage à partir de celles-ci des espaceurs (9) sur les structures en polysilicium des domaines actifs qui ont été obtenus par attaque,
(i) on dépose une deuxième couche (12) de polysilicium,
(j) on effectue une implantation du type p⁻ ou du type n⁻ en fonction de la structure à produire,
(k) on structure la deuxième couche (12) de polysilicium,
(I) on effectue un traitement thermique, les substances de dopage implantées diffusant de la première couche (4) de polysilicium dans une zone (18a) extérieure sous-jacente de la cuvette (2), et les substances de dopage implantées diffusant de la deuxième couche (12) de polysilicium dans une zone comprise entre la zone (18a) extérieure et une zone (19) centrale de la cuvette,
(m) on dépose une troisième couche d'oxyde,
(n) on ménage par attaque des espaceurs (13) sur les bords des structures produites dans la deuxième couche de polysilicium,
(o) on élimine les zones mises à nue de la première couche (7) d'oxyde,
(p) on siliciure les zones mises à nue de la première et de la deuxième couche (4, 12) de polysilicium par introduction d'un métal approprié, et
(q) on produit des contacts (15) métalliques sur le siliciure (14).

2. Procédé suivant la revendication 1,
**caractérisé en ce qu'**on effectue entre le stade (e) et le stade (f) un traitement thermique supplémentaire de sorte que les substances de dopage implantées diffuse de la première couche (4) de polysilicium dans une zone (18a) extérieure sous-jacente de la cuvette (2).

3. Procédé suivant la revendication 2,
**caractérisé en ce que** l'on effectue le stade (1) seulement après les stades (m) et (n).

4. Procédé suivant l'une des revendications 1 à 3,
**caractérisé en ce que** pour la production d'une structure CMOS du type n, on implante d'abord au stade (b), une cuvette (2) du type (p), on dope de façon n⁺ au stade (e), les zones (18a) extérieures de la cuvette par dopage de la première couche (4) de polysilicium est recuit, et ensuite on effectue au stade (j) dans les zones comprises entre les zones (18a) extérieures et la zone (19) centrale de la cuvette un dopage des deux côtés du type n⁻.

5. Procédé suivant l'une des revendications 1 à 3,
**caractérisé en ce que** pour produire une structure CMOS du type p, on implante d'abord au stade (p), une cuvette (2) du type (n), on dope de façon p⁺ au stade (e) les zones (18a) extérieures de la cuvette par dopage de la première couche (4) de polysilicium et ensuite au stade (j), on effectue dans les zones comprises entre les zones (18a) extérieures et la zone (19) centrale un dopage du type p⁻ des deux côtés de la deuxième couche (12) de polysilicium.

6. Procédé suivant l'une des revendications 1 à 3,
**caractérisé en ce que** pour la production d'un transistor npn, on implante d'abord au stade (b), une cuvette (2) du type n, on dope de façon n⁺ au stade (e), les zones (18) de la première couche (4) de polysilicium et ensuite, on effectue au stade (j) dans une zone comprise entre une zone (19a) extérieure et la zone (19) centrale de la cuvette, un dopage du type p⁻ d'un seul côté pour la production d'une base.

7. Procédé suivant l'une des revendications 1 à 3,
**caractérisé en ce que** pour la production d'un transistor npn, on implante d'abord au stade (p), une cuvette (2) du type p, on dope de façon p⁺ au stade (e), les zones (18) de la première couche (4) de polysilicium et ensuite on effectue au stade (j), dans une zone comprise entre une zone (18a) extérieure et la zone (19) centrale de la cuvette un dopage du type n⁻ d'un seul côté pour la production d'une base.

8. Procédé suivant l'une des revendications précédentes,
**caractérisé en ce que** l'on produit une pluralité de structures de même type.

9. Procédé suivant l'une des revendications 6 à 8,
**caractérisé en ce que** l'on règle lors de la production du transistor la largeur de la base par un espaceur (9) des deux côtés.

10. Procédé suivant l'une des revendications précédentes,
**caractérisé en ce que** l'on effectue la mise en contact du polysilicium par des trous métallisés de contact.
